# EUROPÄISCHE PATENTSCHRIFT

(11) **EP 2 436 242 B1**
(45) Veröffentlichungstag und Bekanntmachung des Hinweises auf die Patenterteilung: **09.01.2013**
(21) Anmeldenummer: 10721292.0
(22) Anmeldetag: 28.04.2010
(51) Int. Cl.: H05K 1/18, H01L 25/16

(54) **OPTOELEKTRONISCHES MODUL UND VERFAHREN ZUR HERSTELLUNG EINES OPTOELEKTRONISCHEN MODULS**
OPTOELECTRONIC MODULE AND METHOD FOR PRODUCING AN OPTOELECTRONIC MODULE
MODULE OPTOÉLECTRONIQUE ET PROCÉDÉ DE FABRICATION D'UN MODULE OPTOÉLECTRONIQUE

(30) Priorität: 27.05.2009 DE 102009022901
(43) Veröffentlichungstag der Anmeldung: 04.04.2012
(73) Patentinhaber: OSRAM Opto Semiconductors GmbH, 93055 Regensburg (DE)
(72) Erfinder: BOGNER, Georg, 93138 Lappersdorf (DE); GRUBER, Stefan, 93077 Bad Abbach (DE)
(74) Vertreter: Epping - Hermann - Fischer
(86) Internationale Anmeldenummer: PCT/DE2010/000492
(87) Internationale Veröffentlichungsnummer: WO 2010/136006

(56) Entgegenhaltungen:
- DE-A1-102007 020 475

## Beschreibung

Die vorliegende Erfindung betrifft ein optoelektronisches Modul mit einem strahlungsemittierenden Halbleiterbauelement, einem elektrischen Bauelement und einem Trägersubstrat und ein Verfahren zur Herstellung eines derartigen optoelektronischen Moduls.

Es sind Module bekannt, die eine Mehrzahl von elektrischen und/oder optischen Bauelementen aufweisen, wobei die einzelnen Bauelemente dabei nebeneinander beispielsweise auf einem Trägersubstrat angeordnet sind. Dabei können die einzelnen elektrischen Bauelemente in einem gemeinsamen Gehäuse angeordnet sein, wobei durch die laterale Anordnung der elektrischen und/oder optischen Bauelemente diese Gehäuse derart groß ausgestaltet sind, dass alle Bauelemente nebeneinander angeordnet werden können. Zur Montage der einzelnen Bauelemente finden dabei je nach Art der Bauelemente unterschiedliche Techniken, wie beispielsweise Löten oder Kleben, Anwendung.

Die Druckschrift DE 10 2007 020 475 A1 betrifft eine Leiterplatte mit einer Kavität und ein Herstellungsverfahren hierfür.

Der Erfindung liegt die Aufgabe zugrunde, ein verbessertes optoelektronisches Modul anzugeben, das sich insbesondere durch eine reduzierte Modulgröße auszeichnet. Weiter ist es Aufgabe der Erfindung, ein Verfahren zur Herstellung eines optoelektronischen Moduls anzugeben, das sich insbesondere durch einen reduzierten Kosten- und Herstellungsaufwand auszeichnet.

Diese Aufgaben werden durch ein optoelektronisches Modul mit den Merkmalen des Patentanspruchs 1 und ein Verfahren zur Herstellung eines solchen optoelektronischen Moduls mit den Merkmalen des Anspruchs 15 gelöst. Vorteilhafte Ausführungsformen und bevorzugte Weiterbildungen des Moduls und des Verfahrens zur Herstellung des Moduls sind Gegenstand der abhängigen Ansprüche.

Erfindungsgemäß ist ein optoelektronisches Modul vorgesehen, das ein strahlungsemittierendes Bauelement, ein elektrisches Bauelement und ein Trägersubstrat aufweist. Das Trägersubstrat weist eine Oberseite und eine Unterseite auf, wobei auf der Unterseite erste elektrische Anschlüsse und auf der Oberseite zweite elektrische Anschlüsse angeordnet sind. Das elektrische Bauelement ist auf der Oberseite des Trägersubstrats angeordnet und mit den ersten elektrischen Anschlüssen elektrisch leitend verbunden ist. Das strahlungsemittierende Halbleiterbauelement ist auf der von dem Trägersubstrat abgewandten Seite des elektrischen Bauelements angeordnet und weist Leitstrukturen auf, die mit den zweiten elektrischen Anschlüssen elektrisch leitend verbunden sind.

Das strahlungsemittierende Halbleiterbauelement und das elektrische Bauelement werden demnach nicht nebeneinander auf dem Trägersubstrat montiert. Insbesondere werden das strahlungsemittierende Halbleiterbauelement und das elektrische Bauelement so zueinander angeordnet, dass das elektrische Bauelement unter dem strahlungsemittierenden Halbleiterbauelement sitzt. Insbesondere ist das elektrische Bauelement zwischen strahlungsemittierenden Halbleiterbauelement und Trägersubstrat angeordnet. Das elektrische Bauelement und das strahlungsemittierende Halbleiterbauelement sind also übereinander gestapelt und bilden einen sogenannten Stack.

Die Modulgröße kann dadurch mit Vorteil verringert werden. Insbesondere verringert sich die laterale Ausdehnung des Moduls. Unter lateraler Ausdehnung ist insbesondere die Grundfläche des Moduls zu verstehen.

Bevorzugt ist das strahlungsemittierende Halbleiterbauelement zentriert zum elektrischen Bauelement angeordnet. Das elektrische Bauelement und das strahlungsemittierende Halbleiterbauelement weisen vorzugsweise jeweils eine vertikale Mittelachse auf, die bevorzugt direkt übereinander angeordnet sind. Besonders bevorzugt weisen das elektrische Bauelement und das strahlungsemittierende Halbleiterbauelement eine gemeinsame vertikale Mittelachse auf.

Die Größe des Moduls, insbesondere die Grundfläche des Moduls, ist dabei nicht abhängig von der Anzahl der elektrischen und/oder strahlungsemittierenden Bauelemente, da diese übereinander gestapelt sind.

Vorzugsweise ist die Größe des Moduls so gestaltet, dass sich außerhalb einer Montagefläche des elektrischen Bauelements auf der Oberseite des Trägersubstrats freie Flächen befinden, die beispielsweise mit Lötkontakten ausgestattet sind. Diese Kontakte dienen beispielsweise als zweite elektrische Anschlüsse für das strahlungsemittierende Halbleiterbauelement und/oder als weitere elektrische Anschlüsse für weitere elektrische Bauelemente.

Vorzugsweise weist die Oberseite des Trägersubstrats mindestens zwei zweite Anschlüsse, bevorzugt sechs zweite Anschlüsse, und die Unterseite mindestens zwölf erste Anschlüsse, beispielsweise achtzehn erste Anschlüsse, auf.

Die Bauelementanzahl eines solchen Stacks ist nicht auf zwei begrenzt. Beispielsweise können mehrere strahlungsemittierende Halbleiterbauelemente übereinander auf dem elektrischen Bauelement angeordnet sein. In diesem Fall sitzt jeweils ein strahlungsemittierendes Halbleiterbauelement zentriert auf einem weiteren strahlungsemittierenden Halbleiterbauelement, wobei der Stapel aus strahlungsemittierenden Halbleiterbauelementen wiederum zentriert auf dem elektrischen Bauelement angeordnet ist. Das elektrische Bauelement ist dabei auf dem Trägersubstrat montiert.

Bei einer bevorzugten Ausführungsform des optoelektronischen Moduls ist das Trägersubstrat eine Leiterplatte, das strahlungsemittierende Halbleiterbauelement eine LED und das elektrische Bauelement ein IC zur Ansteuerung der LED.

Der IC (IC: integrated circuit), also der integrierter Schaltkreis, kann dabei aktive oder passive Bauelemente, wie beispielsweise Widerstände oder Kondensatoren, aufweisen. Die aktiven und/oder passiven Bauelemente sind dabei insbesondere zur Ansteuerung der LED geeignet.

Das strahlungsemittierende Bauelement weist bevorzugt eine Montageseite auf, mit der das strahlungsemittierende Bauelement auf dem elektrischen Bauelement angeordnet ist. Weiter weist das strahlungsemittierende Bauelement vorzugsweise eine der Montageseite gegenüberliegende Strahlungsaustrittsseite auf, aus der die von dem strahlungsemittierenden Halbleiterbauelement emittierte Strahlung vorzugsweise das Modul verlässt.

Das Trägersubstrat kann weiter ein Gehäuse sein, in dem der Stack aufweisend das strahlungsemittierende Halbleiterbauelement und das elektrische Bauelement angeordnet sind.

Vorzugsweise sind die Leitstrukturen aus dem strahlungsemittierenden Halbleiterbauelement herausragende elektrisch leitende Stege.

Bevorzugt ragen die elektrisch leitenden Stege jeweils an einer Seitenfläche des strahlungsemittierenden Halbleiterbauelements heraus. Besonders bevorzugt sind die elektrisch leitenden Stege derart geformt, dass sie von dem strahlungsemittierenden Halbleiterbauelement weg in Richtung des Trägersubstrats gekrümmt sind.

Die Stege sind insbesondere vorzugsweise so aus dem strahlungsemittierenden Halbleiterbauelement geführt, dass sie bereichsweise parallel zu der Oberseite des Trägersubstrats geführt sind. Bevorzugt weisen die elektrisch leitenden Stege eine derartige Biegung auf, dass die elektrisch leitenden Stege in Richtung des Trägersubstrats hin gebogen sind. Bevorzugt sind die strahlungsemittierenden Halbleiterbauelemente durch die gekrümmten Stege elektrisch leitend mit den zweiten elektrischen Anschlüssen auf dem Trägersubstrat verbunden.

Bei einer bevorzugt Ausgestaltung des optoelektronischen Moduls sind die elektrisch leitenden Stege L-förmig ausgebildet. Insbesondere sind die elektrisch leitenden Stege als auf dem Kopf stehendes L ausgeformt und auf dem Trägersubstrat angeordnet. Dadurch kann über die Stege eine elektrische Verbindung zwischen strahlungsemittierenden Halbleiterbauelement, insbesondere zwischen Seitenflächen des strahlungsemittierenden Halbleiterbauelements, und zweiten elektrischen Anschlüssen des Trägersubstrats erfolgen.

Bei einer weiteren bevorzugten Ausgestaltung sind die elektrisch leitenden Stege Z-förmig ausgebildet. Dadurch sind beispielsweise Teilbereiche der elektrisch leitenden Stege auf den zweiten elektrischen Anschlüssen des Trägersubstrats in Richtung weg von dem strahlungsemittierenden Halbleiterbauelement geführt.

Bei einer weiteren bevorzugten Ausgestaltung des optoelektronischen Moduls sind die elektrisch leitenden Stege J-förmig ausgeführt. Auch in diesem Fall sind Teilbereiche der elektrisch leitenden Stege auf den zweiten elektrischen Anschlüssen des Trägersubstrats geführt, wobei die elektrisch leitenden Stege in Richtung zu dem strahlungsemittierenden Halbleiterbauelement geführt sind.

Bevorzugt sind die elektrisch leitenden Stege Metallstege. Metallstege weisen beispielsweise im Vergleich zu Bonddrähten stabilere Eigenschaften auf, sodass eine stabile elektrische Kontaktierung des strahlungsemittierenden Halbleiterbauelements erzielt werden kann.

Bei einer weiteren bevorzugten Ausgestaltung des optoelektronischen Moduls sind die ersten elektrischen Anschlüsse mittels Durchkontaktierungen durch das Trägersubstrat geführt. Insbesondere sind die Durchkontaktierungen von der Oberseite zur Unterseite des Trägersubstrats geführt. Das elektrische Bauelement kann so an der Unterseite des Trägersubstrats über die Durchkontaktierungen und über die ersten Anschlüsse elektrisch kontaktiert sein. Eine miniaturisierte Modulgröße ermöglicht sich so mit Vorteil.

Bei einer weiteren bevorzugten Ausgestaltung ist das Modul ein oberflächenmontierbares Modul.

Oberflächenmontierbare Module (SMD: surface mounted device) weisen bevorzugt lötfähige Anschlussflächen an der Unterseite auf, insbesondere die ersten elektrischen Anschlüsse, sodass sie beispielsweise direkt auf externe Befestigungselemente gelötet werden können.

Bei einer weiteren bevorzugten Ausgestaltung weist das Trägersubstrat eine Kavität mit einer Höhe H auf, in der das elektrische Bauelement angeordnet ist, wobei die Höhe H der Kavität größer ist als eine Höhe h₁ des elektrischen Bauelements. Das elektrische Bauelement ist von einem Vergussmaterial umhüllt, sodass die Höhe h₁ des elektrischen Bauelements zuzüglich einer Höhe h₂ des Vergussmaterials, das sich über dem elektrischen Bauelement befindet, der Höhe H der Kavität entspricht. Das strahlungsemittierende Halbleiterbauelement ist dabei vorzugsweise auf dem Vergussmaterial angeordnet.

In diesem Fall ist zwischen elektrischem Bauelement und strahlungsemittierenden Halbleiterbauelement das Vergussmaterial angeordnet. Das strahlungsemittierende Halbleiterbauelement ist somit nicht direkt auf dem elektrischen Bauelement angeordnet.

Bevorzugt füllt das Vergussmaterial die Kavität des Trägersubstrats eben auf. Insbesondere bildet sich durch das Vergussmaterial so eine ebene Fläche des Trägersubstrats, auf dem dann das strahlungsemittierende Halbleiterbauelement montiert werden kann. Das elektrische Bauelement ist vorzugsweise vollständig in der Kavität angeordnet.

Es weist das Modul zusätzlich ein Gehäuse auf, in dem das Trägersubstrat, das elektrische Bauelement und das strahlungsemittierende Bauelement angeordnet sind, wobei das Gehäuse strahlungsabsorbierende Partikel aufweist.

Durch die strahlungsabsorbierenden Partikel in dem Gehäuse kann beispielsweise mit Vorteil eine Fremdlichteinwirkung, beispielsweise eine Sonneneinstrahlung, verringert werden. Durch Fremdlichteinfall ergibt sich ein mangelhafter Kontrast durch das an der Emissionsfläche des Moduls und der Strahlungsaustrittsseite des strahlungsemittierenden Bauelements reflektierte Fremdlicht. Durch die strahlungsabsorbierenden Partikel kann der Kontrastmangel mit Vorteil vermieden werden.

Bei einer weiteren bevorzugten Ausgestaltung weist das Modul zusätzlich einen Verguss auf, der das strahlungsemittierende Bauelement umhüllt und weitere strahlungsabsorbierende Partikel aufweist. Unerwünschte Fremdlichteinwirkung, insbesondere ein daraus resultierender Kontrastmangel, kann so mit Vorteil weiter minimiert werden.

Bei einer weiteren bevorzugten Ausgestaltung ist das Trägersubstrat als Mehrschichten-Substrat ausgebildet. Als Mehrschichten-Substrat ist insbesondere ein Substrat zu verstehen, das sich zumindest aus zwei verschiedenen Schichten zusammensetzt. Diese Schichten können sich beispielsweise durch die Materialzusammensetzung unterscheiden. Dadurch kann ein Trägersubstrat erzielt werden, das Bereiche aufweist, die je nach Art der Anwendung unterschiedliche Eigenschaften aufweisen.

Bei einer weiteren bevorzugten Ausgestaltung sind weitere elektrische Bauelemente auf der Oberseite des Trägersubstrats angeordnet und mit weiteren ersten elektrischen Anschlüssen auf der Unterseite des Trägersubstrats elektrisch leitend verbunden, wobei weitere strahlungsemittierende Bauelemente jeweils auf der von dem Trägersubstrat abgewandten Seite eines elektrischen Bauelements angeordnet sind, die mit weiteren zweiten elektrischen Anschlüssen auf der Oberseite des Trägersubstrats elektrisch leitend verbunden sind.

Je nach gewünschter Anwendung des Moduls können so eine Mehrzahl von elektrischen Bauelementen und eine Mehrzahl von strahlungsemittierenden Halbleiterbauelementen Verwendung finden, wobei die elektrischen Bauelemente jeweils zur Ansteuerung eines strahlungsemittierenden Halbleiterbauelements vorgesehen sind. Die strahlungsemittierenden Bauelemente sind jeweils auf einem elektrischen Bauelement angeordnet. Auf dem Trägersubstrat sind somit eine Mehrzahl von Stacks aufweisend jeweils mindestens ein strahlungsemittierendes Bauelement und ein elektrisches Bauelement angeordnet. Durch die gestapelte Anordnung der einzelnen Bauelemente kann insbesondere mit Vorteil der Abstand der strahlungsemittierenden Halbleiterbauelemente zueinander minimiert werden. Ferner können die Mehrzahl von elektrischen Bauelementen und die Mehrzahl von strahlungsemittierenden Bauelementen Platz sparend auf dem Trägersubstrat angeordnet sein. Eine miniaturisierte Modulgröße kann mit Vorteil erzielt werden.

Darüber hinaus wird ein Verfahren zur Herstellung eines solchen optoelektronischen Moduls angegeben.

Gemäß zumindest einer Ausführungsform des Verfahrens wird ein elektrisches Bauelement auf einer Oberseite eines Trägersubstrats montiert, wobei das Trägersubstrat erste elektrische Anschlüsse auf einer Unterseite und zweite elektrische Anschlüsse auf der Oberseite aufweist. Das elektrische Bauelement wird mit den ersten elektrischen Anschlüssen elektrisch leitend verbunden. Anschließend wird ein strahlungsemittierendes Bauelement derart montiert, dass das strahlungsemittierende Halbleiterbauelement auf der von dem Trägersubstrat abgewandten Seite des elektrischen Bauelements angeordnet wird. Weiter werden Leitstrukturen des strahlungsemittierenden Bauelements mit den zweiten elektrischen Anschlüssen des Trägersubstrats elektrisch leitend verbunden.

Das strahlungsemittierende Bauelement wird demnach auf dem elektrischen Bauelement angeordnet, wodurch ein Bauelementstapel, insbesondere ein Stack, hergestellt wird. Die Herstellung eines derartigen Moduls zeichnet sich insbesondere durch ein kostengünstiges und vereinfachtes Herstellungsverfahren aus. Eine kostenoptimierte Herstellung des Moduls kann so mit Vorteil erzielt werden.

Weitere Merkmale, Vorteile, bevorzugte Ausgestaltungen und Zweckmäßigkeit des optoelektronischen Moduls und des Verfahrens zur Herstellung ergeben sich aus den im Folgenden in Verbindung mit den Figuren 1 bis 6 erläuterten Ausführungsbeispielen.

Es zeigen:
- Figur 1: einen schematischen Querschnitt einer Abwandlung eines optoelektronischen Moduls,
- Figuren 2A bis 2C: jeweils eine schematische Ansicht einer Abwandlung eines optoelektronischen Moduls während des Herstellungsverfahrens,
- Figuren 3 und 4: jeweils einen schematischen Querschnitt eines Ausführungsbeispiels eines erfindungsgemäßen optoelektronischen Moduls, und
- Figuren 5 und 6: jeweils einen schematischen Querschnitt einer Abwandlung eines optoelektronischen Moduls.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

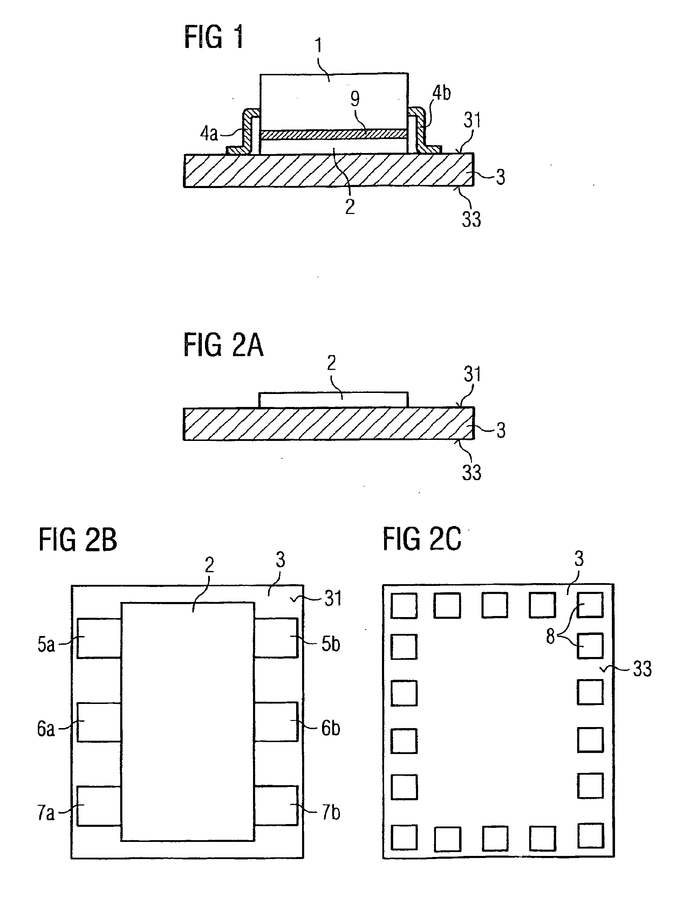

In Figur 1 ist ein schematischer Querschnitt eines optoelektronischen Moduls dargestellt, das ein elektrisches Bauelement 2, einen Trägerkörper 3 und ein strahlungsemittierendes Halbleiterbauelement 1 aufweist. Das Trägersubstrat 3 weist auf einer Unterseite 33 erste elektrische Anschlüsse und auf einer Oberseite 31 zweite elektrische Anschlüsse auf. Das elektrische Bauelement 2 ist auf der Oberseite 31 des Trägersubstrats 3 angeordnet und mit den ersten elektrischen Anschlüssen des Trägersubstrats 3 elektrisch leitend verbunden. Auf der von dem Trägersubstrat 3 abgewandten Seite des elektrischen Bauelements 2 ist das strahlungsemittierende Halbleiterbauelement 1 angeordnet. Das strahlungsemittierende Halbleiterbauelement 1 kann beispielsweise mittels einer Haftvermittlungsschicht oder einer Klebeschicht 9 auf dem elektrischen Bauelement 2 befestigt sein. Alternativ kann das strahlungsemittierende Halbleiterbauelement 1 mittels eines Lötprozesses auf dem elektrischen Bauelement 2 befestigt sein.

Das elektrische Bauelement 2 und das strahlungsemittierende Halbleiterbauelement 1 sind somit übereinander angeordnet, insbesondere gestapelt. Vorzugsweise ist das strahlungsemittierende Halbleiterbauelement 1 zentriert auf dem elektrischen Bauelement 2 angeordnet. Bevorzugt stimmt die Grundfläche des strahlungsemittierenden Halbleiterbauelements 1 mit der Grundfläche des elektrischen Bauelements 2 nahezu überein, sodass das strahlungsemittierende Halbleiterbauelement 1 das elektrische Bauelement 2 lateral in Draufsicht auf den Stapel nicht überragt.

Das strahlungsemittierende Halbleiterbauelement 1 weist bevorzugt eine Montageseite auf, die dem elektrischen Bauelement 2 zugewandt ist. Auf der der Montageseite gegenüberliegenden Seite befindet sich bevorzugt die Strahlungsaustrittsseite des strahlungsemittierenden Bauelements. Die von dem strahlungsemittierenden Halbleiterbauelement 1 emittierte Strahlung tritt hauptsächlich bevorzugt an der Strahlungsaustrittsseite aus dem Halbleiterbauelement 1 aus.

Das strahlungsemittierende Halbleiterbauelement 1 weist ferner Leitstrukturen 4a, 4b auf, die mit den zweiten elektrischen Anschlüssen des Trägersubstrats 3 elektrisch leitend verbunden sind. Bevorzugt sind die Leitstrukturen 4a, 4b an Seitenflächen des strahlungsemittierenden Halbleiterbauelements 1 angeordnet.

In der Abwandlung der Figur 1 sind die Leitstrukturen 4a, 4b Z-förmig ausgebildet. Insbesondere führen die Leitstrukturen 4a, 4b senkrecht aus Seitenflächen des strahlungsemittierenden Halbleiterbauelements 1 heraus, sind dann bereichsweise parallel zur Oberseite 31 des Trägersubstrats 1 geführt, und weisen anschließend eine Biegung in Richtung des Trägersubstrats 3 auf. Insbesondere führt die Biegung der Leitstrukturen 4a, 4b in Richtung des Trägersubstrats 3 und zu dem Trägersubstrat 3. Auf dem Trägersubstrat 3 weisen die Leitstrukturen 4a, 4b eine weitere Biegung auf, sodass die Leitstrukturen 4a, 4b auf der Oberseite 31 geführt sind. Insbesondere stehen die Leitstrukturen 4a, 4b bereichsweise in direktem Kontakt mit den zweiten elektrischen Anschlüssen. Die Leitstrukturen 4a, 4b führen vorzugsweise auf der Oberseite 31 des Trägersubstrats 3 von dem strahlungsemittierenden Halbleiterbauelement 1 weg.

Das Trägersubstrat 3 ist bevorzugt eine Leiterplatte, auf der zur elektrischen Kontaktierung des elektrischen Bauelements 2 auf der Unterseite 33 erste elektrische Anschlüsse und zur elektrischen Kontaktierung des strahlungsemittierenden Bauelements 1 auf der Oberseite 31 zweite elektrische Anschlüsse, beispielsweise Leiterbahnen, geführt sind.

Das strahlungsemittierende Halbleiterbauelement 1 ist vorzugsweise eine LED oder ein LED-Chip. Alternativ kann das strahlungsemittierende Halbleiterbauelement 1 eine in einem LED-Gehäuse angeordnete Halbleiterschichtstruktur aufweisen, die strahlungsemittierende Eigenschaften, also insbesondere eine aktive Schicht aufweist. Weiter kann in dem LED-Gehäuse ein Vergussmaterial eingebracht sein, sodass der Halbleiterschichtenstapel beispielsweise mit einem Epoxidharz vergossen ist. Somit kann das strahlungsemittierende Halbleiterbauelement 1 nicht nur ein LED-Chip oder eine LED sein, sondern insbesondere als LED-Package ausgebildet sein.

Bevorzugt weist das LED-Package drei LED-Chips auf. Besonders bevorzugt sind die drei LED-Chips RGB-LEDs. Das bedeutet, dass einer der LED-Chips rote Strahlung, einer der LED-Chips grüne Strahlung und einer der LED-Chips blaue Strahlung emittieren.

Das elektrische Bauelement 1 ist vorzugsweise ein IC zur Ansteuerung der LED, der LED-Chips oder des LED-Package.

Durch die gestapelte Anordnung der Bauelemente, insbesondere des elektrischen Bauelements 2 und des strahlungsemittierenden Halbleiterbauelements 1, reduziert sich mit Vorteil die Grundfläche eines derartigen Moduls. Insbesondere kann so ein miniaturisiertes Modul erzielt werden. Insbesondere reduziert sich die Grundfläche des Moduls um die benötigte Montagefläche des strahlungsemittierenden Halbleiterbauelements 1, da dieses direkt auf dem elektrischen Bauelement 2 angeordnet ist. Eine Anordnung der Bauelemente nebeneinander auf dem Trägersubstrat 3 wird so mit Vorteil vermieden.

Die Leitstrukturen 4a, 4b sind vorzugsweise aus dem strahlungsemittierenden Halbleiterbauelement 1 herausragende elektrisch leitende Stege. Besonders bevorzugt sind die elektrisch leitenden Stege 4a, 4b Metallstege. Diese zeichnen sich insbesondere mit Vorteil durch stabile Eigenschaften aus und sind nicht, wie beispielsweise Bonddrähte, flexibel biegbar.

Das Trägersubstrat 3 ist bevorzugt als Mehrschichten-Substrat ausgebildet. Das bedeutet, dass das Trägersubstrat 3 mindestens zwei Schichten aufweist, die übereinander angeordnet sind. So kann das Trägersubstrat 3 bereichsweise auf spezielle Anforderungen angepasst sein.

Bevorzugt ist das Modul ein oberflächenmontierbares Modul. Das Modul der Figur 1 kann bevorzugt auf der Unterseite 33 extern montiert und elektrisch angeschlossen werden.

Auf der Oberseite 31 des Trägersubstrats 3 können weitere elektrische Bauelemente angeordnet sein und mit weiteren ersten elektrischen Anschlüssen auf der Unterseite 33 des Trägersubstrats 3 elektrisch leitend verbunden sein (nicht dargestellt). In diesem Fall sind vorzugsweise auf den weiteren elektrischen Bauelementen weitere strahlungsemittierende Bauelemente angeordnet. Insbesondere ist auf jeweils einem weiteren elektrischen Bauelement ein weiteres strahlungsemittierendes Bauelement angeordnet. Demnach sind auf der Oberseite 31 des Trägersubstrats 3 eine Mehrzahl von Stapeln bzw. Stacks aufweisend mindestens ein elektrisches Bauelement und ein strahlungsemittierendes Bauelement angeordnet. Die Stacks können mit Vorteil nahe zueinander angeordnet sein. Ein Platz sparendes Modul mit einer Mehrzahl von Stacks kann so mit Vorteil erzielt werden.

Ferner besteht auch die Möglichkeit, eine Mehrzahl von strahlungsemittierenden Halbleiterbauelementen übereinander zu stapeln und auf einem elektrischen Bauelement anzuordnen (nicht dargestellt).

In den Figuren 2A bis 2C sind schematische Ansichten eines optoelektronischen Moduls in der Herstellung dargestellt. Figur 2A zeigt insbesondere einen schematischen Querschnitt eines Moduls mit einem Trägersubstrat 3 und einem darauf angeordneten elektrischen Bauelement 2. Figur 2B zeigt dazu eine Aufsicht auf das Modul der Figur 2A. Figur 2C zeigt eine Unteransicht des Moduls aus Figur 2A.

In Figur 2A ist ein Trägersubstrat 3 dargestellt, das eine Oberseite 31 und eine Unterseite 33 aufweist. Auf der Oberseite 31 sind zweite elektrische Anschlüsse angeordnet. Auf der Oberseite 31 ist ferner ein elektrisches Bauelement 2 angeordnet. Die Unterseite 33 des Trägersubstrats 3 weist erste elektrische Anschlüsse auf.

In Figur 2B ist die Oberseite 31 des Trägersubstrats 3 in Draufsicht gezeigt. Die Oberseite 31 weist zweite elektrische Anschlüsse 5a, 5b, 6a, 6b, 7a, 7b auf. Insbesondere weist das Trägersubstrat 3 in der Abwandlung der Figur 2B sechs zweite elektrische Anschlüsse 5a, 5b, 6a, 6b, 7a, 7b auf.

Die zweiten elektrischen Anschlüsse 5a, 5b, 6a, 6b, 7a, 7b dienen bevorzugt zur elektrischen Kontaktierung des strahlungsemittierenden Bauelements. In den Figur 2A bis 2C ist das strahlungsemittierende Halbleiterbauelement der Übersicht halber nicht dargestellt.

Bevorzugt ist das strahlungsemittierende Bauelement ein LED-Package, insbesondere RGB-LEDs. In diesem Fall wird beispielsweise der rote strahlungsemittierende LED-Chip mit den zweiten Anschlüssen 5a, 5b, der grüne strahlungsemittierende LED-Chip mit den zweiten Anschlüssen 6a, 6b und der blaue strahlungsemittierende LED-Chip mit den zweiten Anschlüssen 7a, 7b elektrisch leitend kontaktiert.

Das elektrische Bauelement 2 ist insbesondere ein IC, bevorzugt ein gekapselter IC, der zur Ansteuerung des strahlungsemittierenden Bauelements, insbesondere der RGB-LEDs geeignet ist.

In Figur 2C ist die Unterseite des Trägersubstrats 3 der Abwandlung der Figur 2B, also die von dem elektrischen Bauelement 2 abgewandte Seite des Trägersubstrats 3, gezeigt. An der Unterseite des Trägersubstrats 3 sind die ersten elektrischen Anschlüsse 8 angeordnet. Mittels der ersten elektrischen Anschlüsse 8 wird der IC von der Unterseite des Trägersubstrats 3 elektrisch angeschlossen. Insbesondere weist die Unterseite 33 achtzehn erste elektrische Anschlüsse 8 auf.

In den Abwandlungen der Figuren 2A bis 2C sind die ersten elektrischen Anschlüsse 8 der Unterseite des Trägersubstrats 3 mittels Durchkontaktierungen durch das Trägersubstrat 3 mit dem IC 2 auf der Oberseite 31 des Trägersubstrats 3 elektrisch leitend verbunden.

Um das optoelektronische Modul der Abwandlung der Figuren 2A bis 2C zu vervollständigen, wird auf dem elektrischen Bauelement 2, insbesondere auf der von dem Trägersubstrat 3 abgewandten Seite des elektrischen Bauelements 2, ein strahlungsemittierendes Halbleiterbauelement, insbesondere RGB-LEDs, angeordnet (nicht dargestellt). Die LED-Chips werden insbesondere jeweils mit zwei der zweiten elektrischen Anschlüsse 5a, 5b, 6a, 6b, 7a, 7b elektrisch leitend verbunden.

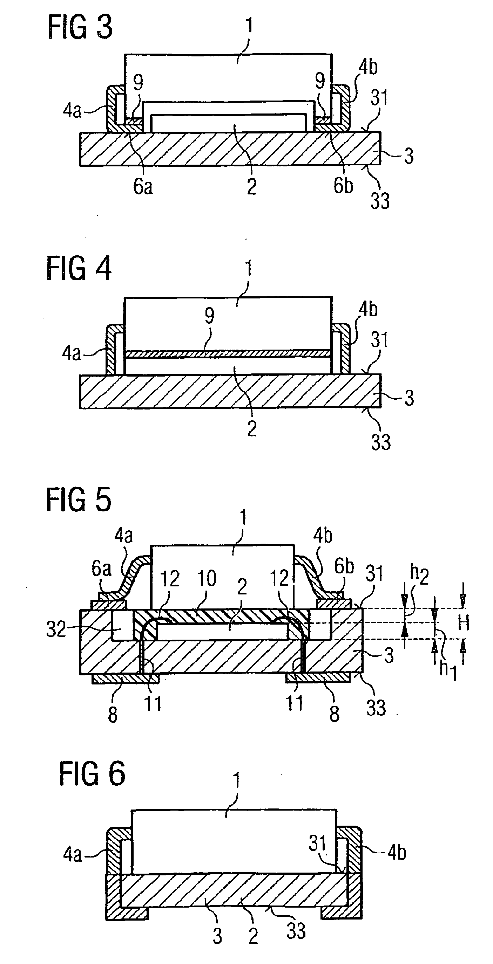

Figur 3 zeigt eine weitere Abwandlung eines optoelektronischen Moduls, insbesondere einen schematischen Querschnitt eines Moduls.

Im Unterschied zu dem in Figur 1 dargestellten Modul sind die elektrisch leitenden Stege 4a, 4b J-förmig ausgebildet. Insbesondere sind die elektrisch leitenden Stege 4a, 4b auf der Oberseite 31 des Trägersubstrats 3 in Richtung des strahlungsemittierenden Halbleiterbauelements 1 geführt. Somit ist die zweite Krümmung der elektrisch leitenden Stege 4a, 4b entgegen der zweiten Krümmung der elektrisch leitenden Stege aus Figur 1 gerichtet.

Ferner weist das strahlungsemittierende Halbleiterbauelement 1 im Unterschied zu dem strahlungsemittierenden Bauelement aus Figur 1 eine Aussparung auf. Die Aussparung befindet sich insbesondere auf der Montageseite des strahlungsemittierenden Halbleiterbauelements 1. In der Aussparung ist vorzugsweise das elektrische Bauelement 2 angeordnet.

Ferner ist im Unterschied zu der Abwandlung aus Figur 1 zwischen dem strahlungsemittierenden Halbleiterbauelement 1 und dem elektrischen Bauelement 2 keine

Haftvermittlungsschicht 9 angeordnet. Die Haftvermittlungsschicht 9 befindet sich insbesondere außerhalb der Kavität des strahlungsemittierenden Halbleiterbauelements 1. Zwischen strahlungsemittierenden Halbleiterbauelement 1 und dem elektrischen Bauelement 2 kann somit insbesondere ein Freiraum sein, der beispielsweise Luft enthält.

Bevorzugt ist das strahlungsemittierende Halbleiterbauelement 1 im Randbereich, insbesondere außerhalb der Aussparung, mit einer Haftvermittlungsschicht, Klebeschicht 9 oder einer Lotverbindung montiert. Beispielsweise ist das strahlungsemittierende Halbleiterbauelement 1 im Randbereich auf den Leitstrukturen 4a, 4b montiert.

Das Ausführungsbeispiel der Figur 4 zeigt einen weiteren Querschnitt eines optoelektronischen Moduls. Im Unterschied zu der in Figur 1 dargestellten Abwandlung weisen die elektrisch leitenden Stege 4a, 4b eine L-Form auf. Insbesondere sind die elektrisch leitenden Stege 4a, 4b L-förmig ausgebildet.

Bevorzugt sind die elektrisch leitenden Stege 4a, 4b als umgedrehtes L auf dem Trägersubstrat 3 angeordnet. Die elektrisch leitenden Stege 4a, 4b weisen somit eine Krümmung auf, die in Richtung des Trägersubstrats 3 führt. Eine zweite Krümmung der elektrisch leitenden Stege 4a, 4b ist im Ausführungsbeispiel der Figur 4 nicht ausgebildet.

Die optoelektronischen Module der Figuren 3 und 4 weisen zusätzlich ein Gehäuse auf, in dem das Trägersubstrat 3, das elektrische Bauelement 2 und das strahlungsemittierende Bauelement 1 angeordnet sind und das strahlungsabsorbierende Partikel aufweist (nicht dargestellt). Ferner können die optoelektronischen Module der Figuren 3 und 4 zusätzlich einen Verguss aufweisen, der das strahlungsemittierende Bauelement umhüllt und ebenfalls strahlungsabsorbierende Partikel aufweist (nicht dargestellt).

Die Abwandlung der Figur 5 unterscheidet sich von der Abwandlung der Figur 1 dadurch, dass das Trägersubstrat 3 eine Kavität 32 aufweist. Das elektrische Bauelement 2 ist in der Kavität 32 angeordnet und mittels eines Vergussmaterials 10 vergossen.

Die Kavität des Trägersubstrats 3 weist eine Höhe H auf. Das elektrische Bauelement 2 weist eine Höhe h₁ auf, die kleiner ist als die Höhe H. Somit ist das elektrische Bauelement 2 vollständig in der Kavität 32 angeordnet. Das Vergussmaterial 2 weist oberhalb des elektrischen Bauelements 2 eine Höhe h₂ auf, sodass die Höhe h₁ des elektrischen Bauelements 2 zuzüglich der Höhe h₂ des Vergussmaterials 10 der Höhe H der Kavität entspricht. Das Vergussmaterial 32 schließt somit bündig mit der Oberseite 31 des Trägersubstrats 3 ab.

Auf dem Vergussmaterial 32 ist das strahlungsemittierende Halbleiterbauelement 1 angeordnet und mittels elektrisch leitenden Stegen 4a, 4b mit zweiten elektrischen Anschlüssen 6a, 6b des Trägersubstrats 3 elektrisch leitend verbunden.

Das elektrische Bauelement 2 ist mittels Bonddrähten 12 mit Durchkontaktierungen 11, die durch das Trägersubstrat 3 führen, elektrisch leitend verbunden. Die Durchkontaktierungen 11 führen insbesondere zu den ersten elektrischen Anschlüssen 8 auf der Unterseite 33 des Trägersubstrats 3.

Die Abwandlung der Figur 6 unterscheidet sich von der Abwandlung der Figur 1 dadurch, dass die Leitstrukturen 4a, 4b des strahlungsemittierenden Halbleiterbauelements 1 an den Seitenflächen des elektrischen Bauelements 2 und des Trägersubstrats 3 derart geführt sind, dass sie bis zur Unterseite 33 des Trägersubstrats 3 reichen. Durch eine derartige Anordnung der Leitstrukturen 4a, 4b kann insbesondere ein oberflächenmontierbares Modul erzielt werden, das mit der Unterseite des Trägersubstrats 3 extern elektrisch angeschlossen werden kann.

## Patentansprüche

1. Optoelektronisches Modul mit
- einem strahlungsemittierenden Halbleiterbauelement (1),
- einem elektrischen Bauelement (2),
- einem Trägersubstrat (3), und
- einem Gehäuse, in dem das Trägersubstrat (3), das elektrische Bauelement (2) und das strahlungsemittierende Halbleiterbauelement (1) angeordnet sind,
wobei
- das Trägersubstrat (3) eine Oberseite (31) und eine Unterseite (33) aufweist,
- auf der Unterseite (33) erste elektrische Anschlüsse (8) und auf der Oberseite (31) zweite elektrische Anschlüsse (5a, 5b, 6a, 6b, 7a, 7b) angeordnet sind,
- das elektrische Bauelement (2) auf der Oberseite (31) des Trägersubstrats (3) angeordnet und mit den ersten elektrischen Anschlüssen (8) elektrisch leitend verbunden ist,
- das strahlungsemittierende Halbleiterbauelement (1) auf der von dem Trägersubstrat (3) abgewandten Seite des elektrischen Bauelements (2) angeordnet ist, und
- das strahlungsemittierende Halbleiterbauelement (1) Leitstrukturen (4a, 4b) aufweist, die mit den zweiten elektrischen Anschlüssen (5a, 5b, 6a, 6b, 7a, 7b) elektrisch leitend verbunden sind, und
- das Gehäuse strahlungsabsorbierende Partikel aufweist.

2. Optoelektronisches Modul nach Anspruch 1, wobei das Trägersubstrat (3) eine Leiterplatte, das strahlungsemittierende Halbleiterbauelement (1) eine LED und das elektrische Bauelement (1) ein IC zur Ansteuerung der LED ist.

3. Optoelektronisches Modul nach einem der vorhergehenden Ansprüche, wobei
die Leitstrukturen (4a, 4b) aus dem strahlungsemittierenden Halbleiterbauelement (1) herausragende elektrisch leitende Stege sind.

4. Optoelektronisches Modul nach Anspruch 3, wobei die elektrisch leitenden Stege (4a, 4b) derart geformt sind, dass sie von dem strahlungsemittierenden Halbleiterbauelement (1) weg in Richtung des Trägersubstrats (3) gekrümmt sind.

5. Optoelektronisches Modul nach Anspruch 4, wobei die elektrisch leitenden Stege (4a, 4b) L-förmig ausgebildet sind.

6. Optoelektronisches Modul nach Anspruch 4, wobei die elektrisch leitenden Stege (4a, 4b) Z-förmig ausgebildet sind.

7. Optoelektronisches Modul nach Anspruch 4, wobei die elektrisch leitenden Stege (4a, 4b) J-förmig ausgebildet sind.

8. Optoelektronisches Modul nach einem der Ansprüche 3 bis 7, wobei
die elektrisch leitenden Stege (4a, 4b) Metallstege sind.

9. Optoelektronisches Modul nach einem der vorhergehenden Ansprüche, wobei
die ersten elektrischen Anschlüsse (8) mittels Durchkontaktierungen (11) durch das Trägersubstrat (3) geführt sind.

10. Optoelektronisches Modul nach einem der vorhergehenden Ansprüche, wobei
- das Trägersubstrat (3) eine Kavität (32) mit einer Höhe H aufweist, in der das elektrische Bauelement (2) angeordnet ist,
- die Höhe H der Kavität (32) größer ist als eine Höhe h₁ des elektrischen Bauelements (2),
- das elektrische Bauelement (2) von einem Vergussmaterial (10) umhüllt ist, so dass die Höhe h₁ des elektrischen Bauelements (2) zuzüglich einer Höhe h₂ des Vergussmaterials (10) über dem elektrischen Bauelement (2) der Höhe H der Kavität (32) entspricht, und
- das strahlungsemittierende Halbleiterbauelement (1) auf dem Vergussmaterial (10) angeordnet ist.

11. Optoelektronisches Modul nach einem der vorhergehenden Ansprüche,
zusätzlich aufweisend einen Verguss, der das strahlungsemittierende Halbleiterbauelement (1) umhüllt, und der strahlungsabsorbierende Partikel aufweist.

12. Optoelektronisches Modul nach einem der vorhergehenden Ansprüche, wobei
das Trägersubstrat (3) als Mehrschichten-Substrat ausgebildet ist.

13. Optoelektronisches Modul nach einem der vorhergehenden Ansprüche, wobei
- weitere elektrische Bauelemente (2) auf der Oberseite (31) des Trägersubstrats (3) angeordnet und mit weiteren ersten elektrischen Anschlüssen (8) auf der Unterseite (33) des Trägersubstrats (3) elektrisch leitend-verbunden sind, und
- weitere strahlungsemittierende Bauelemente (1) jeweils auf der von dem Trägersubstrat (3) abgewandten Seite eines elektrischen Bauelements (2) angeordnet sind, die mit weiteren zweiten elektrischen Anschlüssen (5a, 5b, 6a, 6b, 7a, 7b) auf der Oberseite (31) des Trägersubstrats (3) elektrisch leitend verbunden sind.

14. Verfahren zur Herstellung eines optoelektronischen Moduls nach einem der vorhergehenden Ansprüche, mit den Verfahrensschritten:
- Montieren eines elektrischen Bauelements (2) auf eine Oberseite (31) eines Trägersubstrats (3), das erste elektrische Anschlüsse (8) auf einer Unterseite (33) und zweite elektrische Anschlüsse (5a, 5b, 6a, 6b, 7a, 7b) auf der Oberseite (31) aufweist, wobei das elektrische Bauelement (2) mit den ersten elektrischen Anschlüssen (8) elektrisch leitend verbunden wird,
- Montieren eines strahlungsemittierenden Halbleiterbauelements (1) derart, dass das strahlungsemittierende Halbleiterbauelement (1) auf der von dem Trägersubstrat (3) abgewandten Seite des elektrischen Bauelements (2) angeordnet wird und Leitstrukturen (4a, 4b) des strahlungsemittierenden Bauelements (1) mit den zweiten elektrischen Anschlüssen (5a, 5b, 6a, 6b, 7a, 7b) elektrisch leitend verbunden werden.

## Claims

1. An optoelectronic module comprising
- a radiation-emitting semiconductor component (1),
- an electrical component (2),
- a carrier substrate (3), and
- a housing in which the carrier substrate (3), the electrical component (2) and the radiation-emitting semiconductor component (1) are arranged,
wherein
- the carrier substrate (3) comprises a top (31) and a bottom (33),
- first electrical connections (8) are arranged on the bottom (33) and second electrical connections (5a, 5b, 6a, 6b, 7a, 7b) are arranged on the top (31),
- the electrical component (2) is arranged on the top (31) of the carrier substrate (3) and is electrically conductively connected with the first electrical connections (8),
- the radiation-emitting semiconductor component (1) is arranged on the side of the electrical component (2) remote from the carrier substrate (3), and
- the radiation-emitting semiconductor component (1) comprises conductive structures (4a, 4b) which are electrically conductively connected with the second electrical connections (5a, 5b, 6a, 6b, 7a, 7b), and
- the housing comprises radiation-absorbing particles.

2. An optoelectronic module according to claim 1, wherein the carrier substrate (3) is a printed circuit board, the radiation-emitting semiconductor component (1) is an LED and the electrical component (2) is an IC for driving the LED.

3. An optoelectronic module according to any of the preceding claims, wherein
the conductive structures (4a, 4b) are electrically conductive webs which project out from the radiation-emitting semiconductor component (1).

4. An optoelectronic module according to claim 3, wherein the electrically conductive webs (4a, 4b) are shaped such that they are curved away from the radiation-emitting semiconductor component (1) towards the carrier substrate (3).

5. An optoelectronic module according to claim 4, wherein the electrically conductive webs (4a, 4b) are of L-shaped construction.

6. An optoelectronic module according to claim 4, wherein the electrically conductive webs (4a, 4b) are of Z-shaped construction.

7. An optoelectronic module according to claim 4, wherein the electrically conductive webs (4a, 4b) are of J-shaped construction.

8. An optoelectronic module according to any of claims 3 to 7, wherein the electrically conductive webs (4a, 4b) are metal webs.

9. An optoelectronic module according to any of the preceding claims, wherein
the first electrical connections (8) are guided through the carrier substrate (3) by means of vias (11).

10. An optoelectronic module according to any of the preceding claims, wherein
- the carrier substrate (3) has a cavity (32) with a height H, in which the electrical component (2) is arranged,
- the height H of the cavity (32) is greater than a height h₁ of the electrical component (2),
- the electrical component (2) is enclosed by an encapsulating material (10), such that the height h₁ of the electrical component (2) plus a height h₂ of the encapsulating material (10) above the electrical component (2) corresponds to the height H of the cavity (32), and
- the radiation-emitting semiconductor component (1) is arranged on the encapsulating material (10).

11. An optoelectronic module according to any of the preceding claims,
additionally comprising an encapsulation which encloses the radiation-emitting semiconductor component (1) and which comprises radiation-absorbing particles.

12. An optoelectronic module according to any of the preceding claims, wherein
the carrier substrate (3) takes the form of a multilayer substrate.

13. An optoelectronic module according to any of the preceding claims, wherein
- further electrical components (2) are arranged on the top (31) of the carrier substrate (3) and are electrically conductively connected with further first electrical connections (8) on the bottom (33) of the carrier substrate (3), and
- further radiation-emitting components (1) are in each case arranged on the side of an electrical component (2) remote from the carrier substrate (3) and are electrically conductively connected with further second electrical connections (5a, 5b, 6a, 6b, 7a, 7b) on the top (31) of the carrier substrate (3).

14. A method of producing an optoelectronic module according to any of the preceding claims, comprising the method steps:
- mounting an electrical component (2) on the top (31) of a carrier substrate (3), which comprises first electrical connections (8) on the bottom (33) and second electrical connections (5a, 5b, 6a, 6b, 7a, 7b) on the top (31), wherein the electrical component (2) is electrically conductively connected with the first electrical connections (8),
- mounting a radiation-emitting semiconductor component (1) in such a manner that the radiation-emitting semiconductor component (1) is arranged on the side of the electrical component (2) remote from the carrier substrate (3) and conductive structures (4a, 4b) of the radiation-emitting component (1) are electrically conductively connected with the second electrical connections (5a, 5b, 6a, 6b, 7a, 7b).

## Revendications

1. Module optoélectronique comprenant
- un composant semi-conducteur (1) émettant un rayonnement,
- un composant électrique (2),
- un substrat porteur (3), et
- un boîtier, dans lequel sont disposés le substrat porteur (3), le composant électrique (2) et le composant semi-conducteur (1) émettant un rayonnement,
- le substrat porteur (3) présentant un côté supérieur (31) et un côté inférieur (33),
- des premières connexions électriques (8) étant disposées sur le côté inférieur (33) et des secondes connexions électriques (5a, 5b, 6a, 6b, 7a, 7b) étant disposées sur le côté supérieur (31),
- le composant électrique (2) étant disposé sur le côté supérieur (31) du substrat porteur (3) et relié de manière électroconductrice aux premières connexions électriques (8),
- le composant semi-conducteur (1) émettant un rayonnement étant disposé sur le côté, détourné du substrat porteur (3), du composant électrique (2), et
- le composant semi-conducteur (1) émettant un rayonnement présentant des structures conductrices (4a, 4b) qui sont reliées de manière électroconductrice aux secondes connexions électriques (5a, 5b, 6a, 6b, 7a, 7b), et
- le boîtier présentant des particules absorbant le rayonnement.

2. Module optoélectronique selon la revendication 1,
le substrat porteur (3) étant une plaquette à circuit imprimé, le composant semi-conducteur (1) émettant un rayonnement étant une LED et le composant électrique (2) étant un circuit intégré destiné à activer la LED.

3. Module optoélectronique selon l'une quelconque des revendications précédentes,
les structures conductrices (4a, 4b) étant des nervures électroconductrices en saillie du composant semi-conducteur (1) émettant un rayonnement.

4. Module optoélectronique selon la revendication 3,
les nervures électroconductrices (4a, 4b) étant formées de manière à ce qu'elles soient courbées en s'éloignant du composant semi-conducteur (1) émettant un rayonnement en direction du substrat porteur (3).

5. Module optoélectronique selon la revendication 4,
les nervures électroconductrices (4a, 4b) étant réalisées en forme de L.

6. Module optoélectronique selon la revendication 4,
les nervures électroconductrices (4a, 4b) étant réalisées en forme de Z.

7. Module optoélectronique selon la revendication 4,
les nervures électroconductrices (4a, 4b) étant réalisées en forme de J.

8. Module optoélectronique selon l'une quelconque des revendications 3 à 7,
les nervures électroconductrices (4a, 4b) étant des nervures métalliques.

9. Module optoélectronique selon l'une quelconque des revendications précédentes,
les premières connexions électriques (8) étant guidées à travers le substrat porteur (3) au moyen de connexions entières (11).

10. Module optoélectronique selon l'une quelconque des revendications précédentes,
- le substrat porteur (3) présentant une cavité (32) ayant une hauteur H dans laquelle est disposé le composant électrique (2),
- la hauteur H de la cavité (32) étant plus grande qu'une hauteur h₁ du composant électrique (2),
- le composant électrique (2) étant enrobé par un matériau d'encapsulation (10), de sorte que la hauteur h₁ du composant électrique (2) plus une hauteur h₂ du matériau d'encapsulation (10) situé au-dessus du composant électrique (2) correspondent à la hauteur H de la cavité (32), et
- le composant semi-conducteur (1) émettant un rayonnement étant disposé sur le matériau d'encapsulation (10).

11. Module optoélectronique selon l'une quelconque des revendications précédentes,
présentant en plus un encapsulage qui entoure le composant semi-conducteur (1) émettant un rayonnement, et qui présente des particules absorbant le rayonnement.

12. Module optoélectronique selon l'une quelconque des revendications précédentes,
le substrat porteur (3) étant réalisé en tant que substrat multicouches.

13. Module optoélectronique selon l'une quelconque des revendications précédentes,
- des composants électriques supplémentaires (2) étant disposés sur le côté supérieur (31) du substrat porteur (3) et étant reliés de manière électroconductrice à des premières connexions électriques supplémentaires (8) sur le côté inférieur (33) du substrat porteur (3), et
- des composants supplémentaires (1) émettant un rayonnement étant respectivement disposés sur le côté, détourné du substrat porteur (3), d'un composant électrique (2), lesquels sont raccordés de manière électroconductrice à des secondes connexions supplémentaires (5a, 5b, 6a, 6b, 7a, 7b) sur le côté supérieur (31) du substrat porteur (3).

14. Procédé de fabrication d'un module optoélectronique selon l'une quelconque des revendications précédentes, comprenant les étapes de procédé :
- montage d'un composant électrique (2) sur un côté supérieur (31) d'un substrat porteur (3) qui présente des premières connexions électriques (8) sur un côté inférieur (33) et des secondes connexions électriques (5a, 5b, 6a, 6b, 7a, 7b) sur le côté supérieur (31), le composant électrique (2) étant raccordé de manière électroconductrice aux premières connexions électriques (8),
- montage d'un composant semi-conducteur (1) émettant un rayonnement, de manière à ce que le composant semi-conducteur (1) émettant un rayonnement soit disposé sur le côté, détourné du substrat porteur (3), du composant électrique (2) et que des structures conductrices (4a, 4b) du composant semi-conducteur (1) émettant un rayonnement soient reliées de manière électroconductrice aux secondes connexions électriques (5a, 5b, 6a, 6b, 7a, 7b).
